# EUROPÄISCHE PATENTSCHRIFT

(11) **EP 1 578 184 B1**
(45) Veröffentlichungstag und Bekanntmachung des Hinweises auf die Patenterteilung: **06.10.2010**
(21) Anmeldenummer: 04029346.6
(22) Anmeldetag: 10.12.2004
(51) Int. Cl.: G06F 1/20, G05D 23/19, H05K 7/20

(54) **Lüfterregelschaltung mit Übertemperatursignalisierung, insbesondere für eine Spannungsversorgungseinrichtung**
Fan control circuit with overtemperature signalisation, particularly for power supply device
Circuit de régulation d'un ventilateur avec signalisation de dépassement de temperature, notamment pour un dispositif d'une alimentation en courant

(30) Priorität: 16.01.2004 DE 102004002447
(43) Veröffentlichungstag der Anmeldung: 21.09.2005
(73) Patentinhaber: Fujitsu Siemens Computers GmbH, 80807 München (DE)
(72) Erfinder: Busch, Peter, 86179 Augsburg (DE); Huber, Erwin, 81371 München (DE)
(74) Vertreter: Epping - Hermann - Fischer

(56) Entgegenhaltungen:
- US-A- 5 831 405
- US-A- 6 040 668
- US-A1- 2003 002 250
- US-A1- 2003 137 267

## Beschreibung

Die Erfindung betrifft eine Lüfterregelschaltung in einem Baustein.

Lüfterregelschaltungen werden häufig als integrierte Schaltkreise ausgebildet und in einem Chip ausgeliefert (siehe z.B. US 6 040 668). Dabei besitzt der Chip mehrere Anschlußstellen, auch Beinchen bzw. Pins genannt, die intern mit einigen Elementen der integrierten Schaltung verbunden sind und außerhalb zu weiteren Schaltungen oder zur Spannungsversorgung führen. Die Lüfterregelschaltung erzeugt aus einem temperaturabhängigen Signal an einem der Pins zusammen mit einem integrierten, spannungsgesteuerten Oszillator ein variables Taktsignal, um die Drehzahl zu variieren. Das temperaturabhängige Signal wird dabei zumeist von einem einfachen Temperaturmeßwiderstand erzeugt, der einen negativen Temperaturkoeffizienten (NTC) aufweist. Der spannungsgesteuerte Oszillator ist dabei meist ebenfalls mit einem der Pins des Chips verbunden, das zu einem externen RC-Glied führt, durch das eine Grundfrequenz des Taktsignals des spannungsgesteuerten Oszillators einstellbar ist.

Das vom spannungsgesteuerten Oszillator generierte Taktsignal wird einem Drehzahlregelblock zugeführt, der die aktuelle Drehzahl des Lüfters mit einem Sollwert der Drehzahl vergleicht und ein entsprechendes analoges Nachregelsignal an den externen Lüfter abgibt. Die Soll-Drehzahl wird dabei durch das variable Taktsignal dargestellt. Der aktuelle Wert der Drehzahl des Lüfters wird durch eine weitere Schaltung innerhalb des Chips auf geeignete Weise aus der Stromkurvenform des Lüfters ermittelt. Die Drehzahl des Lüfters wird dabei von dem Chip ebenfalls als digitales Ausgangssignal abgegeben.

Ein solcher integrierter Schaltkreis regelt somit die Lüfterdrehzahlregelung in Abhängigkeit des Temperaturmeßwiderstandes. Sinnvollerweise wird damit vor allem der Lüfter der Spannungsversorgungseinrichtung eines Computers geregelt. Der Temperaturmeßwiderstand ist dabei innerhalb der Spannungsversorgung untergebracht und mißt die Verlust- bzw. die Wärmeleistung der Versorgungseinrichtung. Zudem bietet es sich an, bei Temperaturanstieg nicht nur die Lüfterdrehzahl zu ändern, sondern bei einer entsprechend hohen Temperatur eine Übertemperatur zu signalisieren. Bei einer noch höheren Temperatur innerhalb der Spannungsversorgungseinrichtung ist es zweckmäßig, ein Abschaltsignal für den angeschlossenen Computer zu erzeugen, um die Spannungsversorgungseinrichtung vor Beschädigungen zu schützen.

Normalerweise würde man dafür einen Extrapin auf dem Chip vorsehen. Jedoch sind bei dem verwendeten 8-Pin-Baustein bereits alle Beinchen belegt, so dass bei einer Verwendung von weiteren Pins das bisherige 8-Pin-Gehäuse nicht mehr ausreicht. Ein Gehäuse mit einer höheren Anzahl von Anschlußkontakten verursacht jedoch Mehrkosten und eventuell eine Produktionsumstellung, die einen weiteren Aufwand bedeutet.

Es ist daher Aufgabe der Erfindung, eine Regelschaltung vorzusehen, die sowohl eine, Übertemperaturwarnung wie auch eine Übertemperaturabschaltung signalisiert und nur eine möglichst geringe Zahl an Anschlußbeinchen benötigt.

Diese Aufgabe wird mit dem Gegenstand des unabhängigen Patentanspruchs gelöst.

Darin umfaßt die Lüfterregelschaltung einen ersten und einen zweiten Signalausgang, einen Steuerausgang sowie einen ersten und einen zweiten Signaleingang. In der Regelschaltung ist eine Drehzahlsollwertschaltung zur Steuerung einer Drehzahlsollwertfestlegung vorgesehen, die zumindest einen Eingang zur Zuführung eines temperaturabhängigen Signals an dem ersten Signaleingang aufweist und zur Abgabe eines wertkontinuierlichen bzw. analogen Steuersignals abhängig von dem temperaturabhängigen Signal an dem ersten Signaleingang an einen spannungsgesteuerten Oszillator der Lüfterregelschaltung ausgebildet ist. Die Drehzahlsollwertschaltung erzeugt somit aus dem temperaturabhängigen Signal ein wertkontinuierliches Steuersignal, welches einen Drehzahlsollwert repräsentiert. Der spannungsgesteuerte Oszillator weist einen Ausgang zur Abgabe eines von dem wertkontinuierlichen Steuersignal abhängigen Taktsignal auf. Weiterhin ist in der Lüfterregelschaltung eine Pulsidentifikationsschaltung vorgesehen, die mit dem zweiten Signaleingang verbunden ist und zur Bestimmung eines Lüfterdrehzahlwertes aus einem am zweiten Signaleingang der Lüfterregelschaltung anliegenden Signal ausgebildet ist. Die Pulsidentifikationsschaltung erzeugt somit aus einem Signal am zweiten Signaleingang bevorzugt ein digitales Signal, das der Lüfterdrehzahl entspricht. Weiterhin weist die Lüfterregelschaltung einen Regelblock mit einem ersten Eingang und einem Taktsignaleingang auf. Der erste Eingang ist mit einem Ausgang der Pulsidentifikationsschaltung verbunden und zur Zuführung des Lüfterdrehzahlwertes ausgebildet. Der Taktsignaleingang des Regelblocks ist mit dem Ausgang des spannungsgesteuerten Oszillators verbunden. Der Regelblock enthält einen Ausgang, der über einen schaltbaren Inverter mit dem ersten Signalausgang der Lüfterregelschaltung gekoppelt ist. Weiterhin enthält er einen zweiten Ausgang, welcher mit dem Steuerausgang der Lüfterregelschaltung gekoppelt ist. Der Regelblock ist zur Abgabe eines die Lüfterdrehzahl darstellenden Drehzahlsignals an den ersten Ausgang und zur Abgabe eines Lüftersteuersignals an den Steuerausgang der Lüfterregelschaltung ausgebildet. Letztlich weist die Lüfterregelschaltung eine Vergleichsschaltung mit zwei Schwellwerten auf. Die Vergleichsschaltung ist für einen Vergleich des temperaturabhängigen Signals am ersten Signaleingang mit den beiden Schwellwerten ausgebildet. Bei Überschreitung des ersten Schwellwertes gibt sie ein Signal an den schaltbaren Inverter zur Invertierung des Lüfterdrehzahlsignals ab, und bei Überschreiten des zweiten Schwellwertes erzeugt sie ein Übertemperatursignal an dem zweiten Signalausgang der Lüfterregelschaltung.

Die erfindungsgemäße Lüfterregelschaltung erzeugt somit eine Übertemperaturwarnung, indem sie das Signal des Lüfterdrehzahlwertes invertiert. Bei Überschreiten einer zweiten Temperaturschwelle, bei der eine Gefährdung der durch den Lüfter zu kühlenden Einrichtung besteht, gibt die Lüfterregelschaltung ein Übertemperatursignal, bevorzugt zur Abschaltung der gesamten Einrichtung, an den zweiten Signalausgang ab. Die erfindungsgemäße Lüfterregelschaltung erzeugt somit zwei zusätzliche Signale, ohne dabei zusätzliche Anschlüsse vorsehen zu müssen. Bevorzugt ist die erfindungsgemäße Lüfterregelschaltung in einem bereits vorhandenen Baustein mit nur acht Außenkontaktstellen integrierbar, der so kostensparend weiter verwendet wird. Die Signaleingänge bzw. Signalausgänge der Lüfterregelschaltung werden durch die Außenkontaktstellen oder die Pins des Bausteins gebildet.

In einer bevorzugten Ausgestaltung der Erfindung weist der spannungsgesteuerte Oszillator der Lüfterregelschaltung einen Eingang auf, der über den zweiten Signalausgang mit einer externen Schaltung zur Einstellung eines Grundtaktes gekoppelt ist. Bevorzugt weist dabei die Einrichtung zur Frequenzeinstellung eine Kapazität und einen ohmschen Widerstand auf. Sie bildet somit ein RC-Glied. Der spannungsgesteuerte Oszillator ist so ausgebildet, dass er mittels des mit dem zweiten Signaleingang verbundenen RC-Gliedes und des wertkontinuierlichen Steuersignals der Drehzahlsollwertschaltung ein Taktsignal an seinem Ausgang erzeugt.

Durch die Ausbildung mit einem externen RC-Glied läßt sich der spannungsgesteuerte Oszillator für eine Grundfrequenz einstellen. Dies ermöglicht eine höhere Flexibilität der gesamten Lüfterregelschaltung.

In einer Weiterbildung der Erfindung weist die Lüfterregelschaltung einen dritten Signaleingang auf, der mit einem zweiten Eingang der Drehzahlsollwertschaltung verbunden ist. Die Drehzahlsollwertschaltung ist jetzt zur Abgabe eines wertkontinuierlichen Steuersignals, abhängig von einem am zweiten Eingang anliegenden Signal, an den spannungsgesteuerten Oszillator ausgebildet. Der dritte Signaleingang wird dabei bevorzugt für eine externe Drehzahlvorgabe, beispielsweise von der Mutterplatine eines Computers, verwendet, während am ersten Signaleingang das temperaturabhängige Signal anliegt. Die Drehzahlsollwertschaltung erzeugt ein wertkontinuierliches Steuersignal abhängig von den beiden am ersten und am dritten Signaleingang der Lüfterregelschaltung anliegenden Signalen. Auch mit dem dritten Signaleingang wird die Anzahl der Außenkontaktstellen nicht über acht hinaus vergrößert.

In einer anderen bevorzugten Ausgestaltung erfolgt die Kopplung des Regelblocks mit dem Steuerausgang der Lüfterregelschaltung über eine weitere Schaltung, die bevorzugt zur Abgabe eines maximalen Lüftersteuersignals an den Steuerausgang der Lüfterregelschaltung ausgebildet ist, wenn gleichzeitig am zweiten Signalausgang ein Übertemperatursignal anliegt. Dadurch wird am Steuerausgang der Lüfterregelschaltung das maximale Steuersignal für die Lüfterdrehzahl unabhängig von dem Ausgangssignal des Regelblocks erzeugt. Dies ist insbesondere dann vorteilhaft, wenn der Regelblock sowie der spannungsgesteuerte Oszillator bei einem anliegenden Übertemperatursignal abgeschaltet ist und nicht das maximale Lüftersteuersignal abgibt. Dadurch wird vermieden, dass sich bei einem Übertemperatursignal durch einen Fehler der Lüfter abschaltet, die Spannungsversorgung aber weiter aktiv bleibt.

In einer Weiterbildung der Erfindung wird das Übertemperatursignal durch das Versorgungspotential gebildet. Alternativ wird in einer anderen Weiterbildung der Erfindung das Übertemperatursignal durch ein Bezugspotential, bevorzugt das Massepotential, gebildet.

Bevorzugt wird die Lüfterregelschaltung in einem Computersystem mit einer Stromversorgungseinrichtung verwendet, wobei die Stromversorgungseinrichtung zumindest eine Lüftereinrichtung und eine Temperaturmeßvorrichtung umfaßt. Dabei wird das temperaturabhängige Signal von der Temperaturmeßvorrichtung erzeugt und dem ersten Signaleingang der Lüfterregelschaltung zugeführt. Das Übertemperatursignal am zweiten Signalausgang der Lüfterregelschaltung wird zur Abschaltung der Stromversorgungseinrichtung des Computersystems verwendet. Die erfindungsgemäße Lüfterregelschaltung läßt sich so ohne größere Änderungen in bereits vorhandene Computersysteme implementieren. Das bereits vorhandene 8-Pin-Gehäuse kann dabei weiter verwendet werden.

Im weiteren wird die Erfindung anhand von Ausführungsbeispielen im Detail erläutert. Es zeigen:
- Figur 1: ein Blockschaltbild eines ersten Ausführungsbeispiels der Erfindung,
- Figur 2: ein Blockschaltbild eines zweiten Ausführungsbeispiels,
- Figur 3: ein Computersystem mit der erfindungsgemäßen Lüfterregelschaltung.

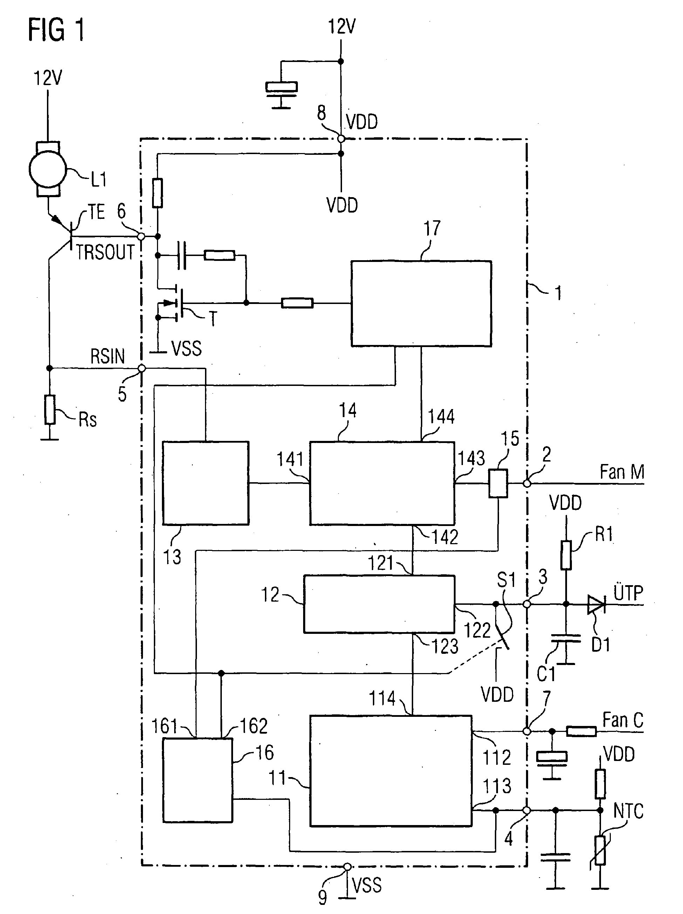

Eine erfindungsgemäße Lüfterregelschaltung ist in Figur 1 zu sehen. Diese ist in einen durch die gestrichelte Linie angedeuteten Baustein eingesetzt, der acht Pins umfaßt, wobei jeder Pin mit einem Signaleingang bzw. Signalausgang der Lüfterregelschaltung 1 verbunden ist. Zwei Pins des Bausteins sind zur Zuführung des Versorgungspotentials VDD, das im Ausführungsbeispiel 12 V beträgt, und des Massepotentials VSS ausgebildet. Diese sind durch die beiden Eingänge 8 bzw. 9 schematisch gekennzeichnet.

Die Lüfterregelschaltung enthält eine Drehzahlsollwertfestlegung 11 mit zwei Eingängen. Ein Eingang der Drehzahlsollwertfestlegung ist mit dem ersten Signaleingang 4 der Lüfterregelschaltung verbunden, der zu einem einen Temperaturmeßwiderstand enthaltenden Spannungsteiler führt. Der zweite Eingang der Drehzahlsollwertfestlegung führt zu dem Signaleingang 7, an den ein Signal FanC für eine externe Drehzahlvorgabe angelegt ist. Dieses Signal wird beispielsweise von einer Mutterplatine eines Computers abgegeben. Weiterhin weist die Drehzahlsollwertschaltung 11 einen Ausgang 114 auf, welcher mit einem spannungsgesteuerten Oszillator 12 verbunden ist.

Der spannungsgesteuerte Oszillator enthält einen weiteren Signalausgang, der zu dem zweiten Signalausgang 3 führt und den Oszillatorpin bildet. Der zweite Signalausgang 3 bzw. der Oszillatorpin ist innerhalb der Lüfterregelschaltung über einen Schalter mit dem Versorgungspotential VDD gekoppelt. Außerhalb der Lüfterregelschaltung und des Gehäuses ist er an eine Diode D1, an einen Kondensator C1 sowie einen Widerstand R1 angeschlossen, dessen anderer Anschluß ebenfalls mit dem Potential VDD verbunden ist.

Durch das Steuersignal der Drehzahlsollwertschaltung 11 am Steuereingang 123 des spannungsgesteuerten Oszillators ist die Frequenz des Taktsignals am Ausgang 121 einstellbar.

Das Taktsignal am Ausgang 121 wird einem Eingang 142 eines digitalen Regelblocks 14 zugeführt. Der digitale Regelblock enthält weiterhin einen zweiten Eingang 141, der mit einer Pulsidentifikationsschaltung 13 verbunden ist. Die Pulsidentifikationsschaltung ist an den Eingangspin Nr. 5 der Lüfterregelschaltung angeschlossen. Dem Eingangspin Nr. 5 wird das Signal RSIN zugeführt, das die Stromkurvenform des Lüfters L1 darstellt. Die Pulsidentifikationsschaltung 13 ermittelt aus dem Signal RSIN in geeigneter Weise die Drehzahl des Lüfters und gibt ein digitales Signal, welches die Drehzahl darstellt, an den ersten Eingang des Regelblocks 14 weiter. Der Regelblock 14 vergleicht das Signal am Eingang 141, welches die aktuelle Drehzahl des Lüfters darstellt, mit der gewünschten Drehzahl, die durch das Taktsignal am Eingang 142 vorgegeben ist. Der Regelblock 14 erzeugt ein analoges Steuersignal und gibt dies am Ausgang 144 aus.

Der Ausgang 144 ist mit einer Schaltung 17 verbunden, die das Steuersignal an ihrem Ausgang über einen Widerstand einem Gate-Anschluß eines Feldeffekttransistors T zuführt. Das Gate des Transistors T steuert die Leitfähigkeit, so dass sich am Steuerausgang 6 der Lüfterregelschaltung ein Potential zwischen VDD und VSS einstellt. Das Potential ergibt das Signal TRSOUT und wird dazu verwendet, den Stromfluß durch einen PNP-Bipolartransistor zu regeln, der mit dem Lüfter L1 verbunden ist. Das Signal TRSOUT am Ausgang 6 steuert somit die Drehzahl des Lüfters.

Der Signaleingang 4 ist außerdem mit einer Vergleichsschaltung 16 verbunden. Die Vergleichsschaltung 16 weist zwei Ausgänge 161 und 162 auf. Der Ausgang 161 führt zu einem Inverter 15, der mit seinem Eingang mit dem Ausgang 143 des Regelblocks 14 verbunden ist. Der Ausgang des Inverters 15 führt zu dem Signalausgang 2 der Lüfterregelschaltung, an den das digitale Drehzahlsignal FanM des Lüfters abgreifbar ist. Das digitale Drehzahlsignal FanM wird von dem Regelblock 143 erzeugt und abhängig von einem Steuersignal der Vergleichsschaltung 16 am Ausgang 161 durch den Inverter 15 invertiert.

Der zweite Ausgang der Vergleichsschaltung 16 führt einerseits zu der Transistorsteuerung 17 und andererseits zu dem Schalter S1. Abhängig von dem Steuersignal am Ausgang 162 der Vergleichsschaltung 16 wird somit das Potential VDD durch den Schalter S1 auf den Oszillatorpin 3 der Lüfterregelschaltung gegeben. Gleichzeitig wird dadurch die Transistorsteuerung 17 so geschaltet, dass an ihrem Ausgang ein Steuersignal für den Gate-Anschluß des Transistors T abgegeben wird, so dass dieser in einen möglichst niedrigohmigen Zustand übergeht. Das Steuersignal TRSOUT am Ausgang 6 wird auf V_{SS} gezogen.

Im Betrieb der erfindungsgemäßen Lüfterregelschaltung in einem Computer ist der Temperatursignaleingang 4 mit einem Temperaturmeßwiderstand NTC verbunden. Dieser ist so angeordnet, dass er eine möglichst genaue Temperaturmessung der Spannungsversorgungseinrichtung des Computers durchführt. Im Ausführungsbeispiel ist der Temperaturmeßwiderstand ein temperaturabhängiger Widerstand mit negativen Temperaturkoeffizienten. Bei steigender Temperatur verringert sich somit sein Widerstand. Im Ausführungsbeispiel beträgt das Spannungssignal am Temperaturmeßeingang 4 der Lüfterregelschaltung bis zu einer Temperatur von 70°C ca. 10 % des Versorgungspotentials VDD. Oberhalb von 70°C sinkt das Potential am Signaleingang weiter ab. Gleichzeitig liegt am Signaleingang 7 das Signal FanC an, das die Drehzahl extern zusätzlich anheben kann. Die Drehzahlsollwertschaltung 11 erzeugt aus beiden Signalen ein Steuersignal und führt dieses über ihren Ausgang 114 dem spannungsgesteuerten Oszillator 12 zu.

Der spannungsgesteuerte Oszillator 12 hat einen zweiten Eingang 122, der an den Oszillatorpin 3 angeschlossen ist und mit einem externen RC-Glied, bestehend aus einem Widerstand R1 und einem Kondensator C1, verbunden ist. Am Oszillatorpin 3 wird zudem auch das Signal zur Übertemperaturabschaltung bereitgestellt. Zu Auswertung des Übertemperatursignals ist eine Diode D1 vorgesehen, die mit dem Überspannungssignaleingang der nicht dargestellten Spannungsversorgungseinrichtung des Computers gekoppelt ist. Durch das Steuersignal am Eingang 123 wird das Taktsignal am Ausgang 121 des spannungsgesteuerten Oszillators variiert. Dadurch variiert auch das Spannungssignal am Oszillatorpin Nr. 3. Dieses ist jedoch so eingestellt, dass bei einem normalen Betrieb die Diode D1 weiterhin sperrt, so dass keine Überspannung der Spannungsversorgungseinrichtung signalisiert wird.

Das Taktsignal am Ausgang 121 des spannungsgesteuerten Oszillators stellt außerdem die Drehzahlvorgabe der Lüfterdrehzahlregelung dar. Zu diesem Zweck wird das Taktsignal einem digitalen Drehzahlregelblock zugeführt. Der digitale Drehzahlregelblock 14 vergleicht das Taktsignal des Oszillators mit der durch die Pulsidentifikationsschaltung ermittelten Lüfterdrehzahl. Ist die vorgegebene Drehzahl aus dem Taktsignal größer als die Ist-Drehzahl des Lüfters, erzeugt er an seinem Ausgang 144 ein Steuersignal, welches der Schaltung 17 zugeführt wird und den Gate-Anschluß des Transistors T so regelt, dass sich die Ausgangsspannung am Ausgang 6 der Lüfterregelschaltung erniedrigt. Dadurch steigt die Leitfähigkeit des Transistors TE, und die Drehzahl des Lüfters L1 erhöht sich. Soll im umgekehrten Fall die Drehzahl erniedrigt werden, so wird durch den Regelblock 14 das Signal am Gate-Anschluß des Transistors T so eingestellt, dass sich sein Widerstand erhöht. Damit erhöht sich die Steuerspannung am Ausgang 6 und die Drehzahl des Lüfters verringert sich.

Gleichzeitig gibt der Regelblock ein digitales Signal an seinem Ausgang 143 ab. Dieses Lüftertachosignal FanM stellt die aktuelle Lüfterdrehzahl dar. Es ist ein periodisches Taktsignal mit einer Impulslänge von ca. 1 bis 4 ms und einem Tastverhältnis von 17 % oder kleiner. Eine geeignete Auswerteelektronik, die mit dem Lüftertachoausgang 2 gekoppelt ist, wertet das Signal aus und erhält somit ein Maß für die Lüfterdrehzahl bzw. die Temperatur des Temperaturmeßwiderstandes.

Gleichzeitig wird das Spannungssignal am Temperaturpin 4 einer Vergleichsschaltung 16 zugeführt. Diese besitzt zwei Schwellwerte. Einen ersten, der für die Signalisierung der Übertemperaturwarnung verwendet wird, und einen zweiten für die Signalisierung einer Übertemperaturabschaltung. Ist das Temperatursignal am Temperaturpin Nr. 4 unterhalb des Schwellwertes für die Übertemperaturwarnung, so gibt die Vergleichsschaltung 16 am Ausgang 161 ein Signal ab, das die Inverterschaltung 15 aktiviert.

Das Lüftertachosignal FanM wird dann invertiert, so dass jetzt das Tastverhältnis 83 % bzw. höher ist. Dieser Zustand kann leicht von dem Zustand ohne eine Temperaturwarnung, also dem Tastverhältnis von 17 % bzw. kleiner, unterschieden werden. Nach wie vor wird auch mit invertiertem Tastverhältnis die Drehzahl des Lüfters signalisiert. Im Fall eines blockierten Lüfters ohne Temperaturwarnung stellt das Lüftertachosignal FanM dauerhaft eine logische 0 dar, bei einem blockierten Lüfter wird am Ausgang 2 durch die Invertierung dauerhaft eine logische 1 signalisiert. Die digitale Auswerteschaltung kann somit zusätzliche Schutzmaßnahmen, beispielsweise die Benachrichtigung eines Benutzers, in einfacher Weise durchführen.

Bei einem weiteren Temperaturanstieg sinkt das Signal am Temperaturmeßpin Nr. 4 der Lüfterregelschaltung unter den zweiten Schwellwert der Vergleichsschaltung 16. Dieser Schwellwert signalisiert eine Übertemperatur, ab der die Spannungsversorgungseinrichtung abgeschaltet werden soll, um eine dauerhafte Beschädigung zu verhindern. Die Vergleichsschaltung 16 gibt an ihrem Ausgang 162 ein Übertemperatursignal ab.

Dieses schaltet den Schalter S1, so dass am Oszillatorpin 3 nun das Versorgungspotential VDD abgreifbar ist. Während die Diode D1 in einem normalen Betriebsmodus in einem nicht leitenden Zustand ist, geht sie nun in einen leitenden Zustand über, und am Eingang der Überspannungserkennung der Stromversorgungseinrichtung liegt annähernd das Potential VDD und damit das Übertemperatursignal ÜTP an. Dadurch schaltet die Stromversorgungseinrichtung ab. Gleichzeitig wird das Signal der Schaltung 17 zugeführt, die unabhängig von dem Steuersignal am Ausgang 144 der Regelschaltung 14 den Transistor T über seinen Gate-Anschluß in einen dauerhaft leitenden Zustand schaltet. Das Lüftersteuersignal am Steuerausgang 6 ist somit immer maximal. Falls die Spannungsversorgung durch einen Fehler nicht abschaltet, läuft der Lüfter somit weiter mit voller Drehzahl. Diese ist insbesondere dann sinnvoll, wenn die Spannungsversorgung wieder eingeschaltet wird, bevor sie abgekühlt ist oder das Übertemperatursignal zurückgesetzt wurde. Zudem wird das Lüftertachosignal FanM durch den Inverter 15 dauerhaft auf eine logische 0 geschaltet. Dies signalisiert ebenfalls die Übertemperaturabschaltung nach außen.

Mit diesen Maßnahmen können ohne aufwendige Implementierungen in einem vorhandenen Gehäuse mit acht Pins beide Übertemperaturinformationen zusätzlich signalisiert werden.

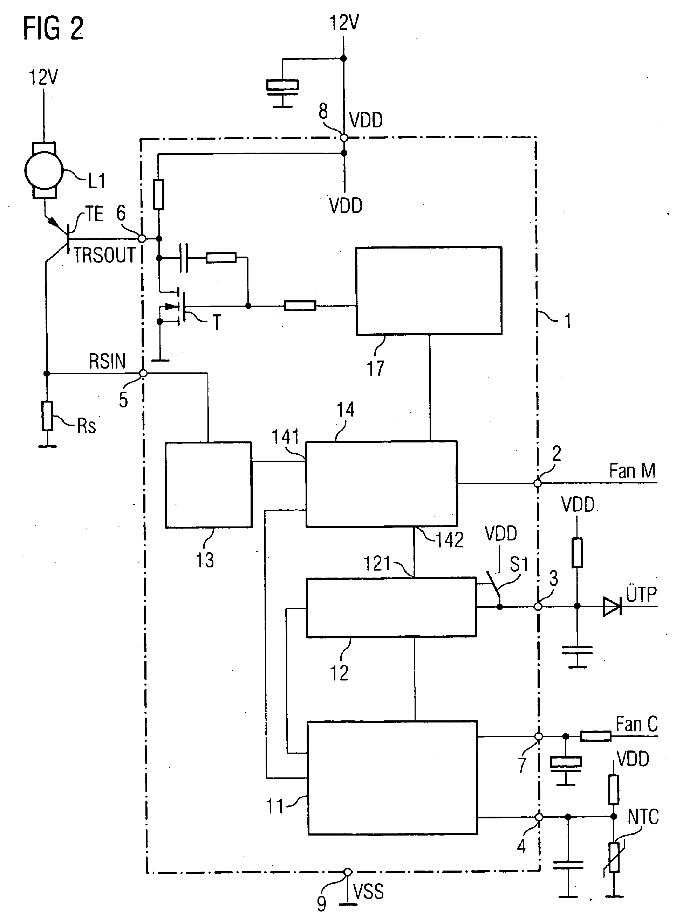

In einer anderen Ausgestaltung der Erfindung gemäß Figur 2 ist die Vergleichsschaltung 16 in der Drehzahlsollwertschaltung 11 implementiert. Weiterhin ist auch der Inverter 15 in dem Regelblock 14 realisiert. Die Drehzahlsollwertschaltung erzeugt somit neben dem Steuersignal für den spannungsgesteuerten Oszillator 12 zwei weitere zusätzliche Signale. Das Signal für die Übertemperaturwarnung wird dem Regelblock 14 zugeführt, welcher daraufhin sein Tachoausgangssignal am Ausgang 2 invertiert. Das Signal zur Übertemperaturabschaltung wird von der Drehzahlsollwertschaltung dem spannungsgesteuerten Oszillator zugeführt, der daraufhin den Schalter S1 einschaltet und das Versorgungspotential VDD auf den Oszillatorpin 3 legt.

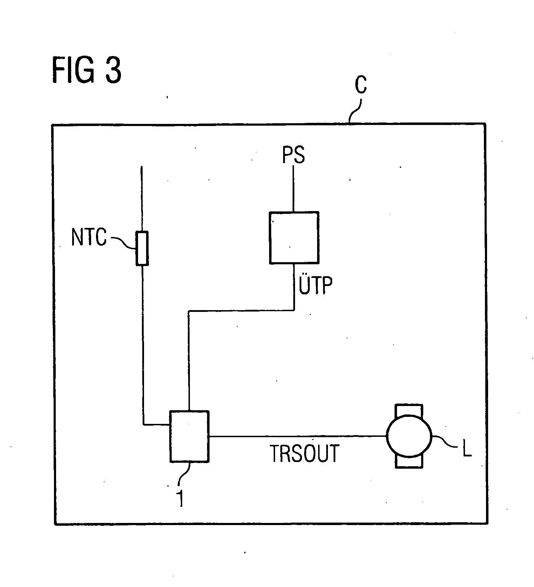

Der erfindungsgemäße Baustein 1 wird bevorzugt in einen Computer eingesetzt, wie es in Figur 3 zu sehen ist. Der Computer C enthält den durch das Signal TRSOUT steuerbaren Lüfter L, den temperaturabhängigen Widerstand NTC als Detektor und das Netzteil PS, das mit dem Pin 3 gekoppelt ist. Durch ein Übertemperatursignal ÜTP auf dem Pin 3 wird das Netzteil abgeschaltet.Insgesamt können so die zusätzlich benötigte Übertemperaturwarnung und die Übertemperatursignalisierung ÜTP auf jeweils Pin 2 bzw. 3 des Bausteins ausgegeben werden. Das bereits verwendete Bausteingehäuse wird weiter genutzt.

### Bezugszeichenliste

- 1:: Lüfterregelschaltung
- 2:: Lüftertachopin
- 3:: Oszillatorpin
- 4:: Temperaturmeßpin
- 5:: Drehzahlpin
- 6:: Steuerpin
- 7:: externe Drehzahlvorgabe
- 8:: Versorgungspotentialpin
- 9:: Massepin
- 11:: Drehzahlsollwertschaltung
- 12:: spannungsgesteuerter Oszillator
- 13:: Pulsidentifikationsschaltung
- 14:: Regelblock
- 15:: Inverter
- 16:: Vergleichsschaltung
- 17:: Schaltung
- S1:: Schalter
- R1:: Widerstand
- C1:: Kondensator
- D1:: Zenerdiode
- T:: Transistor
- TE:: externer Transistor
- Fan M:: Lüftertachosignal
- NTC:: Temperaturmeßwiderstand
- VDD:: Versorgungspotential
- VSS:: Massepotential
- L1:: Lüfter

## Patentansprüche

1. Lüfterregelschaltung (1) in einem Baustein, umfassend:
- einen ersten und einen zweiten Signalausgang (2, 3);
- einen Steuerausgang (6);
- einen ersten Signaleingang (4) und einen zweiten Signaleingang (5);
- eine Drehzahlsollwertschaltung (11), die zumindest einen Eingang zur Zuführung eines temperaturabhängigen Signals an dem ersten Signaleingang (4) aufweist und zur Abgabe eines wertkontinuierlichen Steuersignals abhängig von dem temperaturabhängigen Signal an einen spannungsgesteuerten Oszillator (12) ausgebildet ist;
- den spannungsgesteuerten Oszillator (12), der einen Ausgang (121) zur Abgabe eines von dem wertkontinuirlichen Steuersignal abhängigen Taktsignals aufweist;
- eine Pulsidentifikationsschaltung (13), die mit dem zweiten Signaleingang (5) verbunden ist und zur Bestimmung eines Lüfterdrehzahlwertes aus einem am zweiten Signaleingang (5) der Lüfterregelschaltung (1) anliegenden Signal ausgebildet ist;
- einen Regelblock (14) mit einem ersten Eingang (141) zu Zuführung des Lüfterdrehzahlwertes, mit einem Taktsignaleingang (142), welcher mit dem Ausgang (121) des spannungsgesteuerten Oszillators (12) verbunden ist, wobei der Regelblock (14) über einen schaltbaren Inverter (15) zur Abgabe eines die Lüfterdrehzahl darstellenden Drehzahlsignals an den ersten Signalausgang (2) der Lüfterregelschaltung (1) und zur Abgabe eines Lüftersteuersignals an einen Ausgang ausgebildet ist, welcher mit dem Steuerausgang (6) der Lüfterregelschaltung gekoppelt ist;
- eine Vergleichsschaltung (16) mit zwei Schwellwerten, die für einen Vergleich des temperaturabhängigen Signals mit den beiden Schwellwerten ausgebildet ist, wobei die Vergleichsschaltung (16) bei Erreichen des ersten Schwellwertes zur Abgabe eines Invertierungssignals an den schaltbaren Inverter (15) zur Invertierung des Lüfterdrehzahlsignals und bei Erreichen des zweiten Schwellwertes zur Abgabe eines Übertemperatursignals (ÜTP) an den zweiten Signalausgang (3) ausgebildet ist.

2. Lüfterregelschaltung nach Anspruch 1,
bei dem der spannungsgesteuerte Oszillator (12) einen Eingang aufweist, der mit dem zweiten Signaleingang und mit einer Einrichtung zur Frequenzeinstellung gekoppelt ist.

3. Lüfterregelschaltung nach Anspruch 2,
bei dem die Einrichtung zur Frequenzeinstellung eine Kapazität und einen ohmschen Widerstand aufweist.

4. Lüfterregelschaltung nach einem der Ansprüche 1 bis 3,
bei dem die Lüfterregelschaltung (1) einen dritten Signaleingang (7) aufweist, der mit einem zweiten Eingang der Drehzahlsollwertschaltung (11) verbunden ist, wobei die Drehzahlsollwertschaltung (11) zur Abgabe eines wertkontinuierlichen Steuersignals abhängig von einem am zweiten Eingang anliegenden Signal an den spannungsgesteuerten Oszillator (12) ausgebildet ist.

5. Lüfterregelschaltung nach einem der Ansprüche 1 bis 4,
bei der der Ausgang des Regelblocks (14) über eine Schaltung (17) mit dem Steuerausgang (6) der Lüfterregelschaltung (1) gekoppelt ist, wobei die Schaltung (17) zur Abgabe des maximalen Lüftersteuersignals an den Steuerausgang (6) bei am zweiten Signalausgang (3) anliegendem Übertemperatursignal ausgebildet ist

6. Lüfterregelschaltung nach einem der Ansprüche 1 bis 5,
**dadurch gekennzeichnet, dass**
das Übertemperatursignal durch das Versorgungspotential gebildet ist.

7. Lüfterregelschaltung nach einem der Ansprüche 1 bis 6,
**dadurch gekennzeichnet, dass**
die Lüfterregelschaltung in einem höchstens 8 Außenkontaktstellen umfassenden Baustein untergebracht ist.

8. Verwendung der Lüfterregelschaltung nach einem der Ansprüche 1 bis 7 in einem Computersystem mit einer Stromversorgungseinrichtung, die zumindest eine Lüftereinrichtung und eine Temperaturmeßvorrichtung umfasst,
**dadurch gekennzeichnet, dass**
das temperaturabhängige Signal von der Temperaturmeßvorrichtung erzeugt wird und das Übertemperatursignal am zweiten Signalausgang (3) zur Abschaltung der Stromversorgungseinrichtung des Computersystems verwendet wird.

## Claims

1. Fan control circuit (1) in a module, comprising:
- a first signal output (2) and a second signal output (3);
- a control output (6);
- a first signal input (4) and a second signal input (5);
- a desired speed value circuit (11) which has at least one input for supplying a temperature-dependent signal at the first signal input (4) and is designed to emit a continuous-value control signal to a voltage-controlled oscillator (12) on the basis of the temperature-dependent signal;
- the voltage-controlled oscillator (12) which has an output (121) for emitting a clock signal which is dependent on the continuous-value control signal;
- a pulse identification circuit (13) which is connected to the second signal input (5) and is designed to determine a fan speed value from a signal applied to the second signal input (5) of the fan control circuit (1);
- a control block (14) having a first input (141) for supplying the fan speed value and having a clock signal input (142) which is connected to the output (121) of the voltage-controlled oscillator (12), the control block (14) being designed to emit a speed signal representing the fan speed to the first signal output (2) of the fan control circuit (1) via a switchable inverter (15) and to emit a fan control signal to an output which is coupled to the control output (6) of the fan control circuit;
- a comparison circuit (16) which has two threshold values and is designed to compare the temperature-dependent signal with the two threshold values, the comparison circuit (16) being designed to emit an inversion signal to the switchable inverter (15) for inverting the fan speed signal when the first threshold value is reached and to emit an overtemperature signal (ÜTP) to the second signal output (3) when the second threshold value is reached.

2. Fan control circuit according to Claim 1,
in which the voltage-controlled oscillator (12) has an input which is coupled to the second signal input and to a device for adjusting the frequency.

3. Fan control circuit according to Claim 2,
in which the device for adjusting the frequency has a capacitance and a non-reactive resistor.

4. Fan control circuit according to one of Claims 1 to 3,
in which the fan control circuit (1) has a third signal input (7) which is connected to a second input of the desired speed value circuit (11), the desired speed value circuit (11) being designed to emit a continuous-value control signal to the voltage-controlled oscillator (12) on the basis of a signal applied to the second input.

5. Fan control circuit according to one of Claims 1 to 4,
in which the output of the control block (14) is coupled to the control output (6) of the fan control circuit (1) via a circuit (17), the circuit (17) being designed to emit the maximum fan control signal to the control output (6) when an overtemperature signal is applied to the second signal output (3).

6. Fan control circuit according to one of Claims 1 to 5,
**characterized in that**
the overtemperature signal is formed by the supply potential.

7. Fan control circuit according to one of Claims 1 to 6,
**characterized in that**
the fan control circuit is accommodated in a module comprising at most 8 external contact points.

8. Use of the fan control circuit according to one of Claims 1 to 7 in a computer system having a power supply device which comprises at least one fan device and a temperature measuring apparatus,
**characterized in that**
the temperature-dependent signal is generated by the temperature measuring apparatus and the overtemperature signal at the second signal output (3) is used to disconnect the power supply device of the computer system.

## Revendications

1. Circuit modulaire (1) de régulation d'un ventilateur, qui comprend :
- une première et une deuxième sortie de signaux (2, 3),
- une sortie de commande (6),
- une première entrée de signaux (4) et une deuxième entrée de signaux (5),
- un circuit (11) de définition d'une valeur de consigne de la vitesse de rotation qui présente au moins une entrée qui permet d'amener à la première entrée de signaux (4) un signal dépendant de la température et qui est configuré pour délivrer à un oscillateur (12) commandé par une tension un signal de commande de valeur continue en fonction du signal dépendant de la température,
- l'oscillateur (12) commandé par une tension, qui présente une sortie (121) qui délivre un signal d'horloge qui dépend du signal de commande à valeur continue,
- un circuit (13) d'identification d'impulsions qui est relié à la deuxième entrée de signaux (5) et qui est configuré pour déterminer une valeur de la vitesse de rotation du ventilateur à partir d'un signal appliqué sur la deuxième entrée de signaux (5) du circuit (1) de régulation du ventilateur,
- un bloc de régulation (14) qui présente une première entrée (141) à laquelle est amenée la valeur de vitesse de rotation du ventilateur, et une entrée (142) de signal d'horloge qui est reliée à la sortie (121) de l'oscillateur (12) commandé par une tension, le bloc de régulation (14) étant configuré pour délivrer à la première sortie de signaux (2) du circuit (1) de régulation du ventilateur par l'intermédiaire d'un inverseur commutable (15) un signal de vitesse de rotation qui représente la vitesse de rotation du ventilateur et pour délivrer un signal de commande du ventilateur à une sortie couplée à la sortie de commande (6) du circuit de régulation du ventilateur,
- un circuit comparateur (16) qui présente deux valeurs de seuil et qui est configuré pour comparer le signal dépendant de la température aux deux valeurs de seuil, le circuit comparateur (16) étant configuré pour délivrer un signal d'inversion à l'inverseur commutable (15) en vue d'inverser le signal de vitesse de rotation du ventilateur lorsque la première valeur de seuil est atteinte et pour délivrer un signal de sur-température (ÜTP) à la deuxième sortie de signaux (3) lorsque la deuxième valeur de seuil est atteinte.

2. Circuit de régulation d'un ventilateur selon la revendication 1, dans lequel l'oscillateur (12) commandé par une tension présente une entrée raccordée à la deuxième sortie de signaux et à un dispositif de réglage de fréquence.

3. Circuit de régulation d'un ventilateur selon la revendication 2, dans lequel le dispositif de réglage de fréquence présente une capacité et une résistance ohmique.

4. Circuit de régulation d'un ventilateur selon l'une des revendications 1 à 3, dans lequel le circuit (1) de régulation du ventilateur présente une troisième sortie de signaux (7) qui est reliée à une deuxième entrée du circuit (11) de définition d'une valeur de consigne de vitesse de rotation, le circuit (11) de définition d'une valeur de consigne de vitesse de rotation étant configuré pour délivrer un signal de commande de valeur continue en fonction d'un signal appliqué sur la deuxième entrée à l'oscillateur (12) commandé par une tension.

5. Circuit de régulation d'un ventilateur selon l'une des revendications 1 à 4, dans lequel la sortie du bloc de régulation (14) est raccordée par un circuit (17) à la sortie de commande (6) du circuit (1) de régulation du ventilateur, le circuit (17) étant configuré pour délivrer le signal maximum de commande du ventilateur à la sortie de commande (6) lorsque le signal de sur-température est appliqué sur la deuxième sortie de signaux (3).

6. Circuit de régulation d'un ventilateur selon l'une des revendications 1 à 5, **caractérisé en ce que** le signal de sur-température est formé par le potentiel d'alimentation.

7. Circuit de régulation d'un ventilateur selon l'une des revendications 1 à 6, **caractérisé en ce que** le circuit de régulation du ventilateur peut être placé dans un module qui comprend au plus 8 emplacements pour contacts extérieurs.

8. Utilisation du circuit de régulation de ventilateur selon l'une des revendications 1 à 7 dans un système informatique doté d'un dispositif d'alimentation en courant qui comprend au moins un dispositif de ventilation et un dispositif de mesure de température,
**caractérisée en ce que**
le signal dépendant de la température est formé par le dispositif de mesure de température et le signal de sur-température est utilisé sur la deuxième sortie de signaux (3) pour débrancher le dispositif d'alimentation en courant du système informatique.
